# FASCICULE DE BREVET EUROPEEN

(11) **EP 2 788 747 B1**
(45) Date de publication et mention de la délivrance du brevet: **18.07.2018**
(21) Numéro de dépôt: 12794340.5
(22) Date de dépôt: 30.11.2012
(51) Int. Cl.: G01N 27/414

(54) **PROCEDE DE FABRICATION D'UN TRANSISTOR À EFFET DE CHAMP**
VERFAHREN ZUR HERSTELLUNG EINES FELDEFFEKTTRANSISTORS
METHOD FOR FABRICATING A FIELD EFFECT TRANSISTOR

(30) Priorité: 06.12.2011 FR 1161241
(43) Date de publication de la demande: 15.10.2014
(73) Titulaire: Centre National de la Recherche Scientifique (C.N.R.S.), 75016 Paris (FR)
(72) Inventeur: CHARRIER, Anne, F-13006 Marseille (FR); DALLAPORTA, Hervé, F-13008 Marseille (FR); NGUYEN DUC, Tuyen, F-13009 Marseille (FR)
(74) Mandataire: Lavoix
(86) Numéro de dépôt international: PCT/EP2012/074114
(87) Numéro de publication internationale: WO 2013/083490

(56) Documents cités:
- EP-A1- 2 317 306
- US-A- 4 490 216
- ANNE CHARRIER ET AL: "Direct Stabilization of a Phospholipid Monolayer on H-Terminated Silicon", LANGMUIR, vol. 26, no. 4, 16 février 2010 (2010-02-16), pages 2538-2543, XP055029513, ISSN: 0743-7463, DOI: 10.1021/la9028063
- OTTENBACHER D ET AL: "Developing biosensors with pH-ISFET transducers utilizing lipid bilayer membranes with transport proteins", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, SWITZERLAND, vol. 6, no. 1-3, 1 janvier 1992 (1992-01-01), pages 192-196, XP026553219, ISSN: 0925-4005, DOI: 10.1016/0925-4005(92)80054-2 [extrait le 1992-01-01]

## Description

L'invention concerne un procédé de fabrication d'un transistor à effet de champ.

On connaît déjà dans l'état de la technique des transistors à effet de champ de ce type.

Lorsqu'une variation de charges intervient à la surface du diélectrique de grille, par exemple lorsque des molécules chargées ou des ions sont disposés à la surface du diélectrique de grille ou par application d'une tension de grille, les porteurs de charges électriques présents dans la source et le drain sont attirés dans le substrat semi-conducteur sous le diélectrique de grille par un champ électrique et peuvent former un canal dit de conduction. Un courant circule alors entre la source et le drain. Le transistor est alors dans un état dit passant. La largeur du canal de conduction et l'intensité du courant qui circule entre la source et le drain dépendent de la charge présente à la surface du diélectrique de grille.

Les transistors les plus communément rencontrés dans l'état de la technique présentent un diélectrique de grille constituée par un matériau inorganique, tel que le dioxyde de silicium (SiO₂).

Ce type de transistor, bien que présentant des propriétés électriques intéressantes, n'est pas optimal pour la détection de molécules biologiques chargées ou d'ions en solution. D'autre part, le procédé de fabrication de ce type de transistor comprend une étape d'oxydation thermique du silicium, qui est souvent longue et qui nécessite un recuit dans une gamme de température pouvant s'étendre jusqu'à 800°C.

On rencontre également dans l'état de la technique des transistors à effet de champ comportant un diélectrique de grille constitué par un matériau organique. Le principal inconvénient de ce type de transistor réside dans le fait que la couche de matériau organique constituant le diélectrique de grille présente une épaisseur importante, ce qui réduit les performances électriques du transistor. En effet, plus l'épaisseur du diélectrique de grille est importante, plus la tension à appliquer à la grille pour former le canal de conduction doit être élevée.

Ce type de transistor n'est donc pas optimal pour la détection ou l'étude de molécules biologiques, qui ne supportent pas les fortes tensions.

On rencontre également, par exemple dans le document US 4 490 216, dans l'état de la technique des transistors à effet de champ comportant un diélectrique de grille constitué par à une couche de lipides en contact d'une couche d'oxyde disposée sur substrat semi-conducteur.

Par ailleurs, l'article Anne Charrier ET AL: "Direct Stabilization of a Phospholipid Monolayer on H-Terminated Silicon", Langmuir, vol. 26, 16 February 2010, pages 2538-2543, DOI: 10.1021/la9028063, décrit un procédé pour déposer une couche de lipides sur une surface de silicium non oxydé.

Le but de l'invention est de fabriquer un transistor à effet de champ pouvant être utilisé comme détecteur, et présentant un diélectrique de grille à la sensibilité élevée pour de faibles tensions imposées à la grille.

L'invention a pour but de fournir un procédé de fabrication d'un tel transistor à effet de champ.

A cet effet, l'invention concerne un procédé de fabrication d'un transistor à effet de champ selon les revendications.

L'invention sera mieux comprise à l'aide de la description qui va suivre, donnée uniquement à titre d'exemple et faite en se référant aux dessins annexés, sur lesquels :
- la figure 1 représente une vue en coupe d'un transistor à effet de champ selon l'invention ;
- la figure 2 représente un organigramme de fonctionnement du procédé de fabrication du transistor à effet de champ selon l'invention.

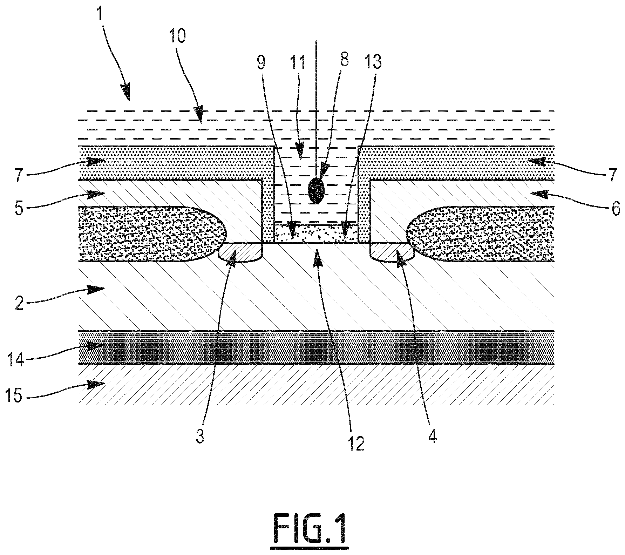

On a en effet illustré sur la figure 1, un transistor à effet de champ désigné par la référence générale 1.

De façon classique et comme cela a été décrit ci-dessus, ce transistor 1 comprend un substrat semi-conducteur 2.

Le substrat semi-conducteur 2 est constitué, de préférence, par un matériau inorganique, tel que du silicium, du graphite ou encore du germanium. L'utilisation d'un matériau inorganique tel que le silicium présente l'avantage de pouvoir être produit à grande échelle et à faible coût.

Le substrat semi-conducteur 2 peut, en variante, être constitué par un matériau organique tel qu'un polymère conducteur, par exemple le PEDOT:PSS. Le PEDOT:PSS est un mélange de deux polymères, le poly(3,4-éthylènedioxythiophène) (PEDOT) et le poly(styrène sulfonate) de sodium (PSS).

Le transistor 1 présente, en outre, deux zones fortement dopées avec des porteurs de charges électriques désignées par les références générales 3 et 4. Ces zones 3 et 4 constituent respectivement la source et le drain.

De façon classique, la source 3 et le drain 4 sont recouverts d'une couche de matériau conducteur jouant le rôle de contact électrique.

Sur la figure 1, les contacts électriques sont désignés par les références générales 5 et 6.

Les contacts électriques 5 et 6 sont, par exemple, réalisés en aluminium.

Les contacts électriques 5 et 6 sont classiquement recouverts d'une couche isolante.

Sur la figure 1, cette couche isolante est désignée par la référence générale 7.

La couche isolante 7 est, par exemple, constituée de nitrure de silicium (SiN) ou d'un polymère tel que le SU-8.

Le transistor 1 présente également une électrode de référence, désignée par la référence générale 8 sur la figure 1.

De façon classique également, le transistor 1 présente une couche diélectrique disposée au-dessus du substrat semi-conducteur 2 entre la source 3 et le drain 4 et formant le diélectrique de grille, désigné par la référence générale 9, du transistor à effet de champ 1.

Le transistor 1 comprend également une solution conductrice, désignée par la référence générale 10, située au-dessus du diélectrique de grille 9.

La solution conductrice 10 est en contact avec le diélectrique de grille 9.

La solution conductrice 10 et l'électrode de référence 8 forment la grille, désignée par la référence générale 11, du transistor à effet de champ 1.

Ainsi, la couche isolante 7 permet d'isoler les contacts électriques 5 et 6 de la solution conductrice 10.

Lorsqu'une variation de charges intervient à la surface du diélectrique de grille 9, par exemple lorsque des molécules chargées ou des ions sont disposés à la surface du diélectrique de grille 9 ou par application d'une tension de grille, les porteurs de charges électriques présents dans la source 3 et le drain 4 sont attirés dans le substrat semi-conducteur 2 sous le diélectrique de grille 9 par un champ électrique et peuvent former un canal dit de conduction. Ce canal de conduction est désigné par la référence générale 12 sur la figure 1. Un courant circule alors entre la source 3 et le drain 4. La largeur du canal de conduction 12 et par conséquent l'intensité du courant dépendent de la charge présente à la surface du diélectrique de grille 9.

Le diélectrique de grille 9 est, selon l'invention, constitué d'une couche de lipides désignée par la référence générale 13.

Cette couche de lipides 13 présente l'avantage de posséder de bonnes caractéristiques électriques, telles qu'un faible courant de fuite, une tension de claquage de l'ordre de 10 MV/cm, ainsi qu'une faible densité de défauts d'interface. Les défauts d'interface sont généralement des charges ou des lacunes piégées à l'interface entre le substrat semi-conducteur 2 et le diélectrique de grille 9 et/ou à l'intérieur du diélectrique de grille 9. Ces défauts d'interface ont tendance à annuler une partie des charges présentes à la surface du diélectrique de grille 9 et tendent donc à diminuer la sensibilité du transistor à effet de champ 1. Dans le transistor à effet de champ 1 selon l'invention, la couche de lipides 13 présente une densité de défauts d'interface de l'ordre de 5.10⁹/cm². Cette faible valeur de densité de défauts d'interface représente une nette amélioration par rapport aux diélectriques de grille inorganique constitués, par exemple, d'oxyde de silicium (SiO₂), d'oxyde de zirconium (ZrO₂), d'oxyde d'hafnium (HfO₂), ou d'oxyde d'yttrium (Y₂O₃), qui présentent une densité de défaut d'interface sensiblement égale à 10¹¹/cm².

Ainsi, cette couche de lipides 13 permet au transistor 1 de présenter des performances électriques élevées et adaptées à la détection de tout objet chargé, tel que des molécules chargées ou des ions.

Selon l'invention, cette couche de lipides 13 est en contact direct avec le substrat semi-conducteur 2.

Avantageusement, la couche de lipides 13 est une monocouche ou une bicouche de lipides.

De manière avantageuse, la couche de lipides 13 présente une épaisseur comprise entre 2 et 8 nm, et de préférence comprise entre 2.4 et 3 nm. Cette épaisseur vaut, par exemple, 2.7 nm.

Ainsi, cette couche de lipides 13 permet au transistor 1 de présenter une sensibilité élevée lorsque de faibles tensions sont imposées à la grille 11. C'est le cas, par exemple, lorsque des molécules chargées ou ions sont disposés à la surface du diélectrique de grille 9. Dans cet exemple, les tensions imposées à la grille sont typiquement inférieures à 2 V.

De manière avantageuse également, la couche de lipides 13 comprend des lipides de synthèse. Ces lipides de synthèse, sont, par exemple, des lipides de synthèse bas coût. Par exemple, le 1,2-bis(10,12-tricosadiynoyl)-*sn*-glycero-3-phosphocholine peut être utilisé pour réaliser la couche de lipides 13.

En outre, la couche de lipides 13 est avantageusement stable en milieu aérien et en milieu liquide.

Par ailleurs, le substrat semi-conducteur 2 comporte avantageusement une face inférieure en contact avec une couche de matériau isolant, elle-même en contact avec une grille arrière constituée d'un matériau conducteur.

Sur la figure 1, la couche de matériau isolant est désignée par la référence générale 14 et la grille arrière est désignée par la référence générale 15.

La grille arrière 15 permet, lorsqu'on lui applique une tension, de modifier la largeur du canal de conduction 12 et d'optimiser les conditions de détection. Elle permet ainsi d'augmenter la sensibilité du transistor à effet de champ 1.

La couche de matériau isolant 14 est, par exemple, constituée de dioxyde de silicium (SiO₂) ou d'un polymère isolant.

La grille arrière 15 est, par exemple, constituée de silicium et ou d'un polymère conducteur.

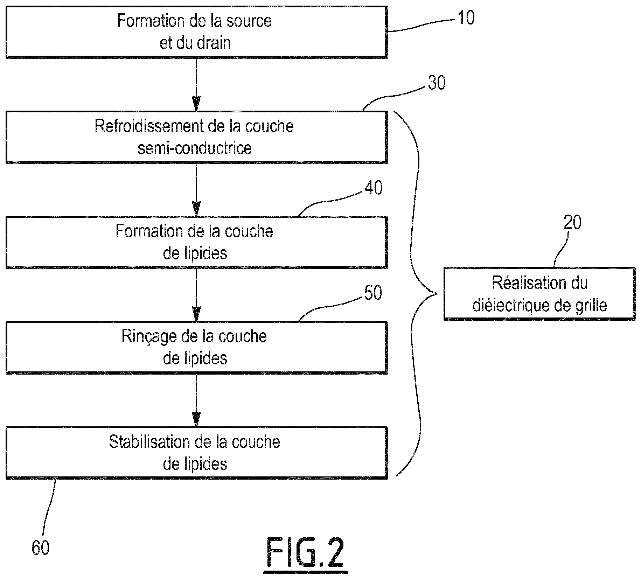

Un mode de réalisation du procédé de fabrication du transistor 1 selon l'invention va maintenant être décrit à l'aide de la figure 2.

Classiquement, le procédé de fabrication débute à l'étape 10 par la formation des zones constituant la source 3 et le drain 4.

De façon classique, la formation de ces zones 3 et 4 comprend une étape de dopage par des porteurs de charges n (ou p). On obtient ainsi une source 3 et un drain 4 fortement dopés par rapport au substrat semi-conducteur 2.

Le procédé selon l'invention se poursuit classiquement par une étape de réalisation des contacts électriques 5 et 6 sur la source 3 et le drain 4.

Le procédé se poursuit, de manière classique également, par une étape d'isolation des contacts électriques 5 et 6, par exemple par dépôt de la couche isolante 7.

Le procédé comprend ensuite une étape 20 de réalisation du diélectrique de grille 9.

Cette étape comprend une première étape 30 de refroidissement du substrat semi-conducteur 2. Le substrat semi-conducteur 2 est refroidi, selon l'invention, à une température sensiblement égale à 10°C.

La couche de lipides 13 est ensuite formée à l'étape 40 par condensation de vésicules lipidiques provoquant la fusion desdits vésicules lipidiques sur le substrat semi-conducteur 2.

L'étape 30 de refroidissement du substrat semi-conducteur 2 permet d'amorcer l'étape 40 de formation de la couche de lipides 13, en faisant condenser les vésicules lipidiques.

L'étape 20 de réalisation du diélectrique de grille 9 se poursuit, de manière avantageuse, par l'étape 50 de rinçage de la couche de lipides 13. Cette étape permet d'éliminer les éventuelles surcouches de lipides, moins stable que la couche de lipides 13 en contact direct avec le substrat semi-conducteur 2.

L'étape 20 de réalisation du diélectrique de grille 9 se termine par une étape 60 de stabilisation de la couche de lipides 13 par polymérisation bidimensionnelle.

Cette étape 60 nécessite une gamme de température comprise, par exemple, entre 10° et 45°C.

On comprend ainsi que le transistor à effet de champ selon l'invention présente des caractéristiques lui permettant de constituer un détecteur avec une bonne sensibilité en utilisant de faibles tensions de grille.

Le procédé de réalisation du diélectrique de grille décrit ci-dessus permet ainsi d'obtenir un diélectrique de grille ultra-mince, homogène et stable à l'air et en milieu liquide. On obtient ainsi un transistor à effet de champ particulièrement adapté pour la détection et l'étude de molécules biologiques chargées ou d'ions en solution.

Par ailleurs, l'utilisation d'une couche de lipides comme diélectrique de grille permet d'éviter l'étape classique d'oxydation thermique du silicium, qui est souvent longue et qui nécessite un recuit dans une gamme de température pouvant s'étendre jusqu'à 800°C. Ce procédé de fabrication à basse température est, en outre, compatible avec les étapes de fabrication de dispositifs microélectroniques.

Les termes « couche semi-conductrice » et « substrat semi-conducteur » sont ici équivalents et sont employés l'un ou l'autre indifféremment.

L'étape de refroidissement de la couche semi-conductrice permet en premier lieu la fusion des vésicules lipidiques à la surface de la couche semi-conductrice.

En second lieu, l'étape de refroidissement de la couche semi-conductrice permet de faciliter la polymérisation de la couche de lipides. En effet, le refroidissement de la couche semi-conductrice entraîne une diminution de l'espace occupé par les lipides, et donc une densification de la couche de lipides. La mobilité des lipides dans une couche de lipides dense étant réduite, la polymérisation de la couche de lipides, nécessaire à sa stabilité à l'air, sera facilitée.

## Revendications

1. Procédé de fabrication d'un transistor à effet de champ (1) du type comportant :
- un substrat semi-conducteur (2) présentant deux zones dopées avec des porteurs de charges électriques formant respectivement une zone source (3) et un zone drain (4) ;
- une couche diélectrique disposée au-dessus du substrat semi-conducteur (2) entre la source (3) et le drain (4) et formant le diélectrique de grille (9) du transistor à effet de champ (1) ;
- une grille (11) constituée d'une électrode de référence (8) et d'une solution conductrice (10), la solution conductrice (10) étant en contact avec le diélectrique de grille (9), le diélectrique de grille (9) étant constitué d'une couche de lipides (13) en contact direct avec le substrat semi-conducteur (2),
le procédé comprenant :
- une étape de formation (10) des zones dopées constituant la source (3) et le drain (4) ;
- une étape de réalisation (20) du diélectrique de grille (9), comprenant une étape (40) de formation de la couche de lipides (13) sur le substrat semi-conducteur (2) par condensation et fusion de vésicules lipidiques sur le substrat semi-conducteur (2),
**caractérisé en ce que** l'étape de réalisation (20) du diélectrique de grille (9) comprend une étape préalable de refroidissement (30) de la couche semi-conductrice (2), au cours de laquelle la couche semi-conductrice (2) est refroidie à une température égale à 10°C, pour amorcer l'étape (40) de formation de la couche de lipides (13) en faisant condenser les vésicules lipidiques.

2. Procédé selon la revendication 1, **caractérisé en ce que** l'étape de réalisation (20) du diélectrique de grille (9) comprend une étape de rinçage (50) de la couche de lipides (8).

3. Procédé selon la revendication 1 ou la revendication 2, **caractérisé en ce que** l'étape de réalisation (20) du diélectrique de grille (9) comprend une étape de stabilisation (60) de la couche de lipides (8) par polymérisation bidimensionnelle.

## Patentansprüche

1. Verfahren zur Herstellung eines Feldeffekttransistors (FET) (1), der umfasst:
- ein Halbleitersubstrat (2) mit zwei Zonen, die mit elektrischen Ladungsträgern dotiert sind, die jeweils eine Source-Zone (3) und eine Drain-Zone (4) bilden;
- eine über dem Halbleitersubstrat (2) zwischen Source (3) und Drain (4) angeordnete dielektrische Schicht, die das Rasterdielektrikum (9) des FET (1) bildet;
- ein Raster (11), bestehend aus einer Referenzelektrode (8) und einer leitfähigen Lösung (10), wobei die leitfähige Lösung (10) mit dem Rasterdielektrikum (9) in Kontakt steht, wobei das Rasterdielektrikum (9) aus einer Lipidschicht (13) besteht, die in unmittelbarem Kontakt mit dem Halbleitersubstrat (2) steht,
wobei das Verfahren umfasst:
- Bilden (10) der dotierten Zonen, die Source (3) und Drain (4) bilden;
- Herstellen (20) des Rasterdielektrikums (9), umfassend Bilden (40) der Lipidschicht (13) auf dem Halbleitersubstrat (2) durch Verdichtung und Fusion von Lipidvesikeln auf dem Halbleitersubstrat (2),
**dadurch gekennzeichnet, dass** die Bildung (20) des Rasterdielektrikums (9) einen vorangestellten Schritt des Kühlens (30) der Halbleiterschicht (2), bei dem die Halbleiterschicht (2) auf eine Temperatur von 10 °C gekühlt wird, um die Bildung (40) der Lipidschicht (13) durch Verdichten der Lipidvesikel einzuleiten.

2. Verfahren nach Anspruch 1, **dadurch gekennzeichnet, dass** die Herstellung (20) des Rasterdielektrikums (9) Spülen (50) der Lipidschicht (8) umfasst.

3. Verfahren nach Anspruch 1 oder 2, **dadurch gekennzeichnet, dass** die Herstellung (20) des Rasterdielektrikums (9) Stabilisieren (60) der Lipidschicht (8) durch zweidimensionale Polymerisierung umfasst.

## Claims

1. Method for manufacturing a field effect transistor (1) of the type comprising:
- a semiconductor substrate (2) having two doped zones with electric charge carriers respectively forming a source zone (3) and a drain zone (4);
- a dielectric layer arranged above the semiconductor substrate (2) between the source (3) and the drain (4) and forming the gate dielectric (9) of the field effect transistor (1);
- a gate (11) consisting of a reference electrode (8) and a conductive solution (10), wherein the conductive solution (10) is in contact with the gate dielectric (9), and the gate dielectric (9) consists of a layer of lipids (13) in direct contact with the semiconductor substrate (2),
wherein the method comprises:
- a step (10) of forming the doped zones constituting the source (3) and the drain (4);
- a step (20) of producing the gate dielectric (9), comprising a step (40) of forming the lipid layer (13) on the semiconductor substrate (2) by condensation and fusion of lipid vesicles on the semiconductor substrate (2),
**characterized in that** the step (20) of producing the gate dielectric (9) comprises a prior step (30) of cooling the semiconductor layer (2), during which the semiconductor layer (2) is cooled to a temperature equal to 10°C, to initiate the step (40) of forming the lipid layer (13) by condensing the lipid vesicles.

2. Method according to claim 1, **characterized in that** the step (20) of producing the gate dielectric (9) comprises a step (50) of rinsing the lipid layer (8).

3. Method according to claim 1 or claim 2, **characterized in that** the step (20) of producing the gate dielectric (9) comprises a step (60) of stabilizing the lipid layer (8) by dimensional polymerization.
